# EUROPEAN PATENT SPECIFICATION

(11) **EP 2 911 172 B1**
(45) Date of publication and mention of the grant of the patent: **10.04.2024**
(21) Application number: 15153655.4
(22) Date of filing: 03.02.2015
(51) Int. Cl.: H01H 47/32

(54) **Electronic switch for simulating a mechanical rocker switch**
Elektronischer Schalter zur Simulation eines mechanischen Wippschalters
Commutateur électronique permettant de simuler une bascule de commutation mécanique

(30) Priority: 19.02.2014 FR 1451328
(43) Date of publication of application: 26.08.2015
(73) Proprietor: InterDigital CE Patent Holdings, 75017 Paris (FR)
(72) Inventor: Marchand, Philippe, 35576 Cesson-Sévigné (FR); Launay, Philippe, 35576 Cesson-Sévigné (FR); Guillot, Philippe, 35576 Cesson-Sévigné (FR)
(74) Representative: Interdigital

(56) References cited:
- EP-A1- 2 056 323
- EP-A1- 2 626 993
- WO-A1-2014/034264

## Description

### 1. Field.

The disclosure relates to the field of power switches and more specifically to that of electronic switches.

### 2. Background.

Devices powered by an external power supply module of "DC pack" type are traditionally switched on or off using a mechanical switch such as a rocker switch or a push switch, which retain the position they are given until operated again by a user. These mechanical switches are chosen in order to offer interrupting capacity characteristics sufficient to avoid causing an electric arc, damaging and then gradually destroying the contacts at the opening of the circuit. Despite this, a mechanical switch has a limited operating life generally defined in number of cycles of opening and closing. For example, a mechanical rocker switch can have an average number of cycles of 25,000 openings and closings before there is a risk of harmful damage to its contacts.

Other solutions, like the one proposed by document EP2056323 (A1) have tried to reduce the power consumption of a power supply module, in a "stand-by" or "off" mode.

An alternative of those diverse solutions consists in using a mechanical switch whose current characteristics are only a few tens of milliamperes and using this component in a control circuit for a MOSFET power transistor which will act as a high interrupting capacity switch capable of being crossed by a high load current.

These mechanical solutions have the advantage of disconnecting the powered item of equipment from the power supply rail and of guaranteeing the absence of residual current when a powered device is configured in an "off" or more precisely a "powered off" mode.

They nevertheless have disadvantages, notably:
- the price of a mechanical solution is substantially higher than that of an electronic solution,
- the gradual and inevitable wearing of the contacts,
- the fact that it is impossible to control these switches using embedded software except by using a relay or bistable relay, but this solution appears unsuitable in the case of powering electronic devices, such as, for example, audiovisual programme receiver-decoders, or network gateways.

The main advantages of mechanical rocker switches or mechanical push switches are their ease of use and the position memory effect, since, once positioned in "on" or "off" mode, they retain their position until operated again.

For the implementation of the memory effect, solutions exist which comprise a tact switch (also called a tact micro-switch) coupled to a MOSFET and to a control unit with microcontroller, having a non-volatile memory. The microcontroller in this case records the position of the power supply circuit ("on" or "off"). However, this solution requires restarting the entire system, after an unexpected disappearance of the power supply current, in order to define which state is stored in the memory and reconfigure the system to "off" mode, if necessary.

This solution requires an almost-permanent state of activation of the microcontroller in order to read the memory and monitor the state of the micro-switch, which results in an energy consumption which is non-negligible and disadvantageous with respect to the maximum values appearing in European Directive 1275/2008 relating to power consumption of equipment in standby mode.

In addition, and in the case of a mechanical solution, a request for a complete switching off cannot be made remotely (via a remote control) or by programming (on detection of an expiry of a timer or of a predefined event).

In addition to the additional cost it incurs, the mechanical switch appears more difficult to incorporate into a cosmetic "front face" of an item of equipment. A software-controlled solution resolves this type of problem, but on the other hand requires a disconnection and reconnection to the mains network in the event of malfunctioning related to a software "crash".

The solutions mentioned all have disadvantages.

### 3. Summary.

The disclosure makes it possible to improve the prior art by proposing an electronic switch for simulating a mechanical rocker switch, the electronic switch being configured to supply power to an electronic device using an input voltage.

For example, it can be an electronic switch for simulating a mechanical rocker switch having a determined current-interrupting capacity, configured to supply power to an electronic device consuming a load current less than or equal to said determined interrupting capacity.

According to a particular embodiment, said electronic switch comprises:
- a micro-switch for the generation of a control signal,
- a bistable circuit whose output state depends on said control signal,
- a switching circuit adapted to an opening and to a closing of a power supply line supplying power to said device, said switching circuit comprising a semi-conductor switching element;
- a memory circuit comprising a reservoir capacitor,
said micro-switch being configured to control opening and/or closing of said switching circuit.

According to a particular embodiment, said generated signal is an electrical pulse. For example, the micro-switch can be a tact micro-switch generating electrical pulses.

According to a particular embodiment, said switching element is a P-channel MOSFET transistor.

According to a particular embodiment, the electronic switch comprises:
- a tact switch for the generation of a control signal,
- a bistable circuit whose output state depends on the control signal,
- a switching circuit adapted to the opening and to the closing of a power supply line supplying power to a device consuming a current less than or equal to the determined interrupting capacity, the switching circuit comprising a P-channel MOSFET transistor,
- a memory circuit comprising a reservoir capacitor,
the tact switch being configured to control opening and closing of the switching circuit.

Advantageously, the electronic switch can maintain its "open" or "closed" state, as a simulated mechanical rocker switch would do, in the event of disappearance of the input voltage.

According to the invention, the memory circuit is adapted to the storage of an "open" or a "closed" mechanical position of the electronic switch, and therefore to the storage of the opening and/or closing of said power supply line, for a predetermined duration according to the value of the reservoir capacitor.

According to an embodiment, said micro-switch has a current-interrupting capacity much less than a current-interrupting capacity of the electronic switch.

According to a particular embodiment, the micro-switch has a current-interrupting capacity less than 100 milliamperes.

According to an embodiment, the electronic switch simulating a mechanical switch is configured to store autonomously the mechanical position of the simulated switch, and therefore said opening and/or closing of said power supply line, for the predetermined duration dependent on the value of the "memory" capacitor in the event of the disappearance of the input voltage.

According to a particular embodiment, said electronic switch is adapted to control said bistable circuit, during a disappearance then a reappearance of said input voltage, according to said stored opening and/or closing.

According to a particular embodiment, said electronic switch is further configured to force the opening of said power supply line.

According to a particular embodiment, said forced opening is implemented by at least one circuit belonging to the group comprising:
- a time delay circuit;
- A control circuit, enabling the control of said switch from a control unit external to said switch.

According to a particular embodiment, said electronic switch further comprises an anti-bounce circuit, able to eliminate an unwanted pulse generated by said micro-switch.

### 4. List of figures.

The disclosure will be better understood, and other specific features and advantages will emerge upon reading the following description, the description making reference to the annexed drawing:

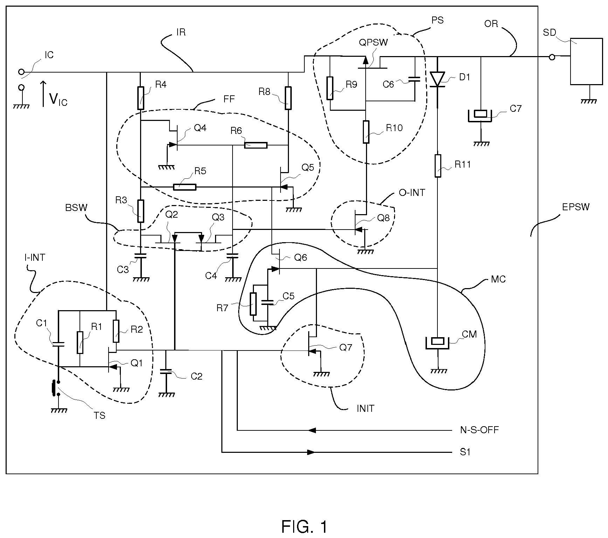

- **Figure 1** shows an electronic switch for simulating a mechanical rocker switch according to a particular and non-restrictive embodiment of the disclosure.

### 5. Description of embodiments.

In figure 1, the modules shown are functional units that may or may not correspond to physically distinguishable units. For example, these modules or some of them are grouped together in a single component, or constituted of functions of the same software. On the contrary, according to other embodiments, some modules are composed of separate physical entities.

**Figure 1** shows an electronic switch EPSW for simulating a mechanical rocker switch according to a particular and non-restrictive embodiment of the disclosure. The power switch circuit PS, comprising a semi-conductor switching element, for example a P-channel MOSFET transistor QPSW, operates as a rocker switch connected between the input rail IR and the output rail OR and has an interrupting capacity PC1 equivalent to that of a rocker switch supplying power to the device SD (the simulated switch being located on the power supply rail) using an input voltage V_{IC} applied to the input connector IC. Cleverly, and due to the assembly of the different elements which constitute it and notably to the presence of the memory circuit MC, the electronic switch EPSW is configured to store in the memory its "open" or "closed" position, corresponding to the position of the simulated mechanical rocker switch, for a duration T1 dependent on the value of the memory capacitor CM. Thus, if the input voltage V_{IC} disappears then reappears, the electronic switch EPSW will be configured to "open" position if it was configured in this position before the disappearance of the input voltage and will be configured to "closed" position if it already was before the disappearance of the input voltage, provided that the input voltage did not disappear for a duration exceeding the maximum storage duration T1. Advantageously, the use of the P-channel MOSFET transistor QPSW enables an opening and a closing of the circuit on the power supply rail constituted of the association of the input rail IR and the output rail OR. This makes it possible, when the powered device SD is connected to earth via other items of equipment, to avoid the risk of constituting a line of floating or indefinite electric potential due to a remote connection to earth. Items of class 1 equipment have the ground of the power supply module connected to earth, which is not the case for items of class 2 equipment. A connection of the ground of the power supply to earth can notably exist in the case of electronic audiovisual programme cable network receiver devices, for example.

The electronic switch comprises a pulse switch, for example a very low interrupting capacity (a few tens of milliamperes maximum) tact switch TS. The tact switch TS and the capacitor C1 coupled to the resistor R1, constitute with the transistor Q1 and the resistor R2 an input interface I-INT of the switch EPSW. The network, or circuit, RC constituted of the resistor R1 and of the capacitor C1 enables an anti-bounce filtering which guarantees a good shaping of the signal from the terminal not connected to the ground of the micro-switch TS and notably contributes to the elimination of unwanted pulses generated by the micro-switch, such as oscillations, bounces and unwanted switching operations. The capacitor C2 constitutes a time delay circuit which generates a delay in the control of a bidirectional switch BSW built around transistors Q2 and Q3, with respect to the assertion of the signal from the micro-switch TS. The bidirectional switch BSW enables the control of a power switch PS, built around the P-channel MOSFET transistor QPSW and which has a high interrupting capacity of several amperes. This control of the power switch PS is implemented via the intermediary of the transistor Q8 which constitutes an output interface O-INT of the electronic switch. A memory circuit MC built around the memory capacitor CM and the transistor Q6 coupled to a network constituted of the resistor R7 and of the capacitor C5 makes it possible to store the state of the output rail OR, taken via the diode D1. Thus, if the input voltage V_{IC} disappears and reappears before the capacitor CM is discharged, the control of the bistable circuit BSW is implemented according to the state of the electronic switch before disappearance of the voltage V_{IC}. Advantageously, the electronic switch EPSW simulates a mechanical rocker switch since its state is retained even in the event of disappearance of the input voltage, and for a duration dependent on the discharge of the capacitor CM. The use of a MOSFET transistor makes it possible to have a high input impedance which limits the discharge current of the capacitor. Advantageously and according to the technology of the components used, the memory circuit MC is adapted to store the "open" or "closed" state of the electronic switch EPSW for around twenty days, without requiring the use of a microcontroller associated with a non-volatile memory.

In the particular embodiment shown, the control line N-S-OFF makes it possible to control the electronic switch from an output port of a control unit, external to the switch, and notably to force the opening of the power supply line. The signal line S1, together with the control line N-S-OFF, enables the reading of the state of operation of the electronic switch by an input of a control unit, if necessary, so that the system can be interfaced with a control unit. It also makes it possible to notify the control unit of an operation of the switch for an opening or a closing of the power supply line. In such an embodiment, during a manual operation of the switch, the opening of the power supply line can be delayed (for example by the capacitor C2) or may require a confirmation from the control unit.

The disclosure is not limited solely to the embodiment described but also applies to any circuit or electronic device as claimed in the appended claims operating as a switch controlled using a switch and configured to store its opening or closing state for a predefined time in the event of disappearance of the input voltage, so that the electronic switch simulates a mechanical rocker switch performing an opening and a closing of the power supply rail of a powered device. The electronic switch being characterised by an interrupting capacity much higher than the interrupting capacity of the micro-switch used for control by the user. The order of magnitude of the ratio of the interrupting capacities being for example a factor of 100 or 1000.

## Claims

1. An electronic switch (EPSW) for simulating a mechanical switch retaining its position, the electronic switch (EPSW) being configured to supply power to an electronic device (SD) using an input voltage (VIC), the electronic switch (EPSW) being **characterized in that** it comprises:
a tact switch or a pulse switch (TS) for generation of a control signal (S1);
a bi-stable circuit (BSW) whose output state depends on the control signal (S1);
a switching circuit (PS) configured to open and to close a power supply line (IR, OR) supplying power to the electronic device (SD), the switching circuit (PS) comprising a semi-conductor switching element;
a memory circuit (MC) configured to store, for at least a first duration, an open or a closed state of the power supply line (IR, OR), the memory circuit comprising a reservoir capacitor (CM), the first duration being dependent on a capacity of the reservoir capacitor; and
the tact switch or the pulse switch (TS) being configured to control opening and closing of the switching circuit (PS).

2. The electronic switch according to claim 1, wherein the memory circuit (MC) is configured to store, autonomously, the open or the closed state of said power supply line (IR, OR) for the first duration in the event of disappearance of the input voltage (VIC).

3. The electronic switch (EPSW) according to claim 1 or 2, wherein said generated signal is an electrical pulse.

4. The electronic switch (EPSW) according to any of claims 1 to 3, wherein the switching element is a P-channel MOSFET transistor (QPSW).

5. The electronic switch according to any one of claims 1 to 4, wherein the tact switch or pulse switch (TS) has a current-interrupting capacity less than a current-interrupting capacity of the electronic switch (EPSW).

6. The electronic switch according to any one of claims 1 to 5, wherein the tact switch or the pulse switch (TS) has a current-interrupting capacity less than 100 milliamperes.

7. The electronic switch (EPSW) according to claim 6, wherein it is configured to control the bi-stable circuit, during a disappearance then a reappearance of the input voltage, according to the stored open or closed state.

8. The electronic switch (EPSW) according to any of claims 1 to 7, wherein it is configured to force the opening of said power supply line.

9. The electronic switch (EPSW) according to claim 8, wherein said forced opening is implemented by at least one circuit belonging to a group comprising:
- a time delay circuit;
- a control circuit, enabling control of the electronic switch from a control unit external to the electronic switch.

10. The electronic switch (EPSW) according to one of claims 1 to 9, further comprising an anti-bounce circuit, configured to eliminate an unwanted pulse generated by the tact switch or the pulse switch (TS).

11. The electronic switch (EPSW) according to any of claims 1 to 10, wherein the mechanical switch retaining its position is a mechanical rocker switch.

12. The electronic switch (EPSW) according to any of claims 1 to 10, wherein the mechanical switch retaining its position is a mechanical push switch.

13. A system comprising an electronic device (SD) and an electronic switch (EPSW) according to any of the preceding claims.

## Patentansprüche

1. Elektronischer Schalter (EPSW) zum Simulieren eines mechanischen Schalters, der seine Position behält, wobei der elektronische Schalter (EPSW) dafür konfiguriert ist, einer elektronischen Vorrichtung (SD) unter Verwendung einer Eingangsspannung (VIC) Leistung zuzuführen, wobei der elektronische Schalter (EPSW) **dadurch gekennzeichnet ist, dass** er umfasst:
einen Taktschalter oder einen Impulsschalter (TS) für die Erzeugung eines Steuersignals (S1);
eine bistabile Schaltung (BSW), deren Ausgangszustand von dem Steuersignal (S1) abhängt;
eine Schaltschaltung (PS), die dafür konfiguriert ist, eine Leistungsversorgungsleitung (IR, OR), die der elektronischen Vorrichtung (SD) Leistung zuführt, zu öffnen und zu schließen, wobei die Schaltschaltung (PS) ein Halbleiterschaltelement umfasst;
eine Speicherschaltung (MC), die dafür konfiguriert ist, für einen geöffneten oder einen geschlossenen Zustand der Leistungsversorgungsleitung (IR, OR) mindestens eine erste Dauer zu speichern, wobei die Speicherschaltung einen Speicherkondensator (CM) umfasst, wobei die erste Dauer von einer Kapazität der Speicherkondensators abhängt; und
wobei der Taktschalter oder der Impulsschalter (TS) dafür konfiguriert ist, das Öffnen und Schließen der Schaltschaltung (PS) zu steuern.

2. Elektronischer Schalter nach Anspruch 1, wobei die Speicherschaltung (MC) dafür konfiguriert ist, den geöffneten oder den geschlossenen Zustand der Leistungsversorgungsleitung (IR, OR) für die erste Dauer im Fall des Verschwindens der Eingangsspannung (VIC) autonom zu speichern.

3. Elektronischer Schalter (EPSW) nach Anspruch 1 oder 2, wobei das erzeugte Signal ein elektrischer Impuls ist.

4. Elektronischer Schalter (EPSW) nach einem der Ansprüche 1 bis 3, wobei das Schaltelement ein P-Kanal-MOSFET-Transistor (QPSW) ist.

5. Elektronischer Schalter nach einem der Ansprüche 1 bis 4, wobei der Taktschalter oder der Impulsschalter (TS) ein kleineres Stromunterbrechungsvermögen als der elektronische Schalter (EPSW) besitzt.

6. Elektronischer Schalter nach einem der Ansprüche 1 bis 5, wobei der Taktschalter oder der Impulsschalter (TS) ein Stromunterbrechungsvermögen kleiner als 100 Milliampere besitzt.

7. Elektronischer Schalter (EPSW) nach Anspruch 6, wobei er dafür konfiguriert ist, die bistabile Schaltung während eines Verschwindens, daraufhin eines Wiedererscheinens der Eingangsspannung in Übereinstimmung mit dem gespeicherten geöffneten oder geschlossenen Zustand zu steuern.

8. Elektronischer Schalter (EPSW) nach einem der Ansprüche 1 bis 7, wobei er dafür konfiguriert ist, das Öffnen der Leistungsversorgungsleitung zu erzwingen.

9. Elektronischer Schalter (EPSW) nach Anspruch 8, wobei das erzwungene Öffnen durch mindestens eine Schaltung implementiert wird, die zu einer Gruppe gehört, die umfasst:
- eine Zeitverzögerungsschaltung;
- eine Steuerschaltung, die die Steuerung des elektronischen Schalters von einer Steuereinheit außerhalb des elektronischen Schalters ermöglicht.

10. Elektronischer Schalter (EPSW) nach einem der Ansprüche 1 bis 9, der ferner eine Entprellschaltung umfasst, die dafür konfiguriert ist, einen durch den Taktschalter oder durch den Impulsschalter (TS) erzeugten unerwünschten Impuls zu beseitigen.

11. Elektronischer Schalter (EPSW) nach einem der Ansprüche 1 bis 10, wobei der mechanische Schalter, der seine Position behält, ein mechanischer Kippschalter ist.

12. Elektronischer Schalter (EPSW) nach einem der Ansprüche 1 bis 10, wobei der mechanische Schalter, der seine Position behält, ein mechanischer Druckschalter ist.

13. System, das eine elektronische Vorrichtung (SD) und einen elektronischen Schalter (EPSW) nach einem der vorhergehenden Ansprüche umfasst.

## Revendications

1. Commutateur électronique (EPSW) pour simuler un commutateur mécanique conservant sa position, le commutateur électronique (EPSW) étant configuré pour alimenter un dispositif électronique (SD) avec une tension d'entrée (VIC), le commutateur électronique (EPSW) étant **caractérisé en ce qu'**il comprend :
un commutateur à contact ou un commutateur à impulsion (TS) pour la génération d'un signal de commande (S1) ;
un circuit bistable (BSW) dont l'état de sortie dépend du signal de commande (S1) ;
un circuit de commutation (PS) configuré pour ouvrir et fermer une ligne d'alimentation (IR, OR) alimentant le dispositif électronique (SD), le circuit de commutation (PS) comprenant un élément de commutation à semi-conducteur ;
un circuit de mémoire (MC) configuré pour mémoriser, pendant au moins une première durée, un état ouvert ou fermé de la ligne d'alimentation (IR, OR), le circuit de mémoire comprenant un condensateur réservoir (CM), la première durée dépendant d'une capacité du condensateur réservoir ; et
le commutateur à contact ou le commutateur à impulsion (TS) étant configuré pour commander l'ouverture et la fermeture du circuit de commutation (PS).

2. Commutateur électronique selon la revendication 1, dans lequel le circuit de mémoire (MC) est configuré pour mémoriser, de manière autonome, l'état ouvert ou fermé de ladite ligne d'alimentation (IR, OR) pendant la première durée en cas de disparition de la tension d'entrée (VIC).

3. Commutateur électronique (EPSW) selon la revendication 1 ou 2, dans lequel le signal généré est une impulsion électrique.

4. Commutateur électronique (EPSW) selon l'une quelconque des revendications 1 à 3, dans lequel l'élément de commutation est un transistor MOSFET à canal P (QPSW).

5. Commutateur électronique selon l'une quelconque des revendications 1 à 4, dans lequel le commutateur à contact ou le commutateur à impulsion (TS) a une capacité de coupure de courant inférieure à une capacité de coupure de courant du commutateur électronique (EPSW).

6. Commutateur électronique selon l'une quelconque des revendications 1 à 5, dans lequel le commutateur à contact ou le commutateur à impulsion (TS) a une capacité de coupure de courant inférieure à 100 milliampères.

7. Commutateur électronique (EPSW) selon la revendication 6, dans lequel il est configuré pour commander le circuit bistable, lors d'une disparition puis d'une réapparition de la tension d'entrée, en fonction de l'état ouvert ou fermé mémorisé.

8. Commutateur électronique (EPSW) selon l'une quelconque des revendications 1 à 7, dans lequel il est configuré pour forcer l'ouverture de ladite ligne d'alimentation.

9. Commutateur électronique (EPSW) selon la revendication 8, dans lequel ladite ouverture forcée est mise en oeuvre par au moins un circuit appartenant à un groupe comprenant :
- un circuit à retard ;
- un circuit de commande, permettant de commander le commutateur électronique à partir d'une unité de commande extérieure au commutateur électronique.

10. Commutateur électronique (EPSW) selon l'une des revendications 1 à 9, comprenant en outre un circuit anti-rebond, configuré pour éliminer une impulsion indésirable générée par le commutateur à contact ou le commutateur à impulsion (TS).

11. Commutateur électronique (EPSW) selon l'une quelconque des revendications 1 à 10, dans lequel le commutateur mécanique conservant sa position est un commutateur à bascule mécanique.

12. Commutateur électronique (EPSW) selon l'une quelconque des revendications 1 à 10, dans lequel le commutateur mécanique conservant sa position est un commutateur à bouton-poussoir mécanique

13. Système comprenant un dispositif électronique (SD) et un commutateur électronique (EPSW) selon l'une quelconque des revendications précédentes.
